# EUROPÄISCHE PATENTSCHRIFT

(11) **EP 2 676 347 B1**
(45) Veröffentlichungstag und Bekanntmachung des Hinweises auf die Patenterteilung: **12.08.2015**
(21) Anmeldenummer: 12709811.9
(22) Anmeldetag: 10.02.2012
(51) Int. Cl.: H02H 9/00, H01C 1/14, H01C 7/12, H01L 23/62, H05K 7/20, H05K 9/00

(54) **ELEKTRONISCHES GERÄT UND SCHUTZELEMENT HIERFÜR FÜR DEN EINSATZ IN EXPLOSIONSGEFÄHRDETEN BEREICHEN**
ELECTRONIC DEVICE AND PROTECTION ELEMENT THEREFOR, FOR USE IN POTENTIALLY EXPLOSIVE AREAS
APPAREIL ÉLECTRONIQUE ET ÉLÉMENT DE PROTECTION POUR CELUI-CI, POUR UNE UTILISATION DANS DES ZONES PRÉSENTANT UN DANGER D'EXPLOSION

(30) Priorität: 14.02.2011 DE 102011004061
(43) Veröffentlichungstag der Anmeldung: 25.12.2013
(73) Patentinhaber: Endress+Hauser GmbH+Co. KG, 79689 Maulburg (DE)
(72) Erfinder: MAYER, Winfried, 89290 Buch (DE); GROZINGER, Roland, 79423 Heitersheim (DE)
(74) Vertreter: Andres, Angelika Maria
(86) Internationale Anmeldenummer: PCT/EP2012/052298
(87) Internationale Veröffentlichungsnummer: WO 2012/110417

(56) Entgegenhaltungen:
- EP-A2- 0 698 895
- DE-A1- 3 834 514
- DE-C1- 4 342 592

## Beschreibung

Die Erfindung betrifft ein Schutzelement mit dem im Falle einer Fehlfunktion einer Baugruppe die über eine übergeordnete Einheit zur Verfügung stehende Leistung sicher in Wärme umwandelbar ist, und ein elektronisches Gerät mit der übergeordneten elektronischen Einheit und mehreren an die übergeordnete Einheit angeschlossenen von dieser mit Energie versorgten elektronischen Baugruppen für den Einsatz in explosionsgefährdeten Bereichen.

In der industriellen Messtechnik werden eine Vielzahl elektronischer Geräte, insb. Messgeräte, wie z.B. Druck-, Temperatur-, Durchfluss oder Füllstandsmessgeräte, eingesetzt. Diese weisen in der Regel eine mit Energie versorgte übergeordnete elektronische Einheit auf, an die mehrere über die übergeordnete Einheit mit Energie versorgte elektronische Baugruppen, z.B. Sensoren, Mess- , Regel- und/oder Auswertungsschaltungen oder Signalverarbeitungen, angeschlossen sind.

In Einsatzgebieten in denen Explosionsgefahr besteht, gelten strenge Sicherheitsvorschriften. Dabei gilt es insb. eine Funkenbildung, die unter Umständen eine Explosion auslösen könnte, zu vermeiden. Entsprechend wird die der übergeordneten Einheit zur Verfügung gestellte Leistung heute regelmäßig durch entsprechende Strom und Spannung begrenzende Schutzschaltungen auf eine vorgegebene Maximalleistung, z.B. auf 1 Watt, begrenzt. Darüber hinaus muss im Gerät sichergestellt werden, dass die den Baugruppen durch die übergeordnete Einheit zur Verfügung gestellte Leistung auch im Falle einer Fehlfunktion einer der Baugruppen keine Funkenbildung verursachen kann. Dies geschieht heute üblicherweise durch eine sichere Umwandlung der Leistung in Wärme. Bei der sicheren Umwandlung wird die von der von der übergeordneten elektronischen Einheit der jeweiligen Baugruppe zur Verfügung gestellte elektrische Leistung im Falle einer Fehlfunktion der Baugruppe derart in Wärme umgesetzt, dass dadurch in der Umgebung befindliche explosive Medien, wie z.B. Gase oder Stäube, nicht entzündet werden können.

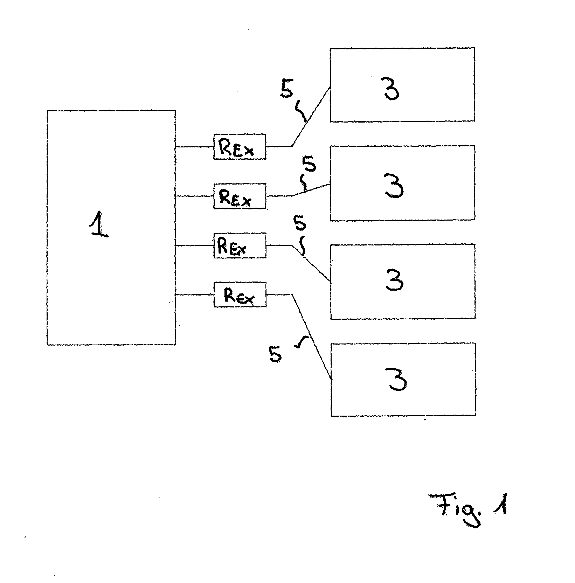

Diese Forderung wird heute üblicher Weise auf die in Fig. 1 dargestellte Weise erfüllt, indem die übergeordnete Einheit 1 an mehrere untergeordnete Baugruppen 3 angeschlossen wird, und in jede die übergeordnete Einheit 1 mit einer der Baugruppen 3 verbindenden Anschlussleitungen 5 jeweils ein so genannter Explosionsschutzwiderstand Rₑₓ eingesetzt wird. Dabei ist die Bauform der Explosionsschutzwiderstände R_{Ex} jeweils so groß anzusetzen, dass jeder einzelne Explosionsschutzwiderstand R_{Ex} im Fehlerfall in der Lage ist, die gesamte über die übergeordnete Einheit 1 zur Verfügung stehende Leistung sicher in Wärme umzusetzen. Größe und Bauform jedes einzelnen Explosionsschutzwiderstands R_{Ex} sind dabei derart auszulegen, dass der Explosionsschutzwiderstand R_{Ex} auch dann nicht überhitzt, wenn über ihn, z.B. aufgrund eines Kurzschlusses in der daran angeschlossenen Baugruppe 3, die gesamte von der übergeordneten Einheit 1 zur Verfügung stehende Leistung in Wärme umgesetzt wird. In Abhängigkeit von der in der übergeordneten Einheit 1 zur Verfügung stehenden Maximalleistung werden hierzu in der Regel Explosionsschutzwiderstände R_{Ex} mit sehr großen mechanischen Abmessungen benötigten, um die Aufnahme und die sichere Ableitung der Wärme zu gewährleisten.

Dies führt aufgrund der erforderlichen Größe der Bauform der Explosionsschutzwiderstände R_{Ex} insb. bei Geräten mit vielen untergeordneten Baugruppen 3 zu einem erheblichen Platzbedarf und steht einer Miniaturisierung und Kostenoptimierung entgegen.

Aus der EP 0 698 895 A2 ist eine elektrische Sicherheitsbarriere für die Verwendung als Schutzeinrichtungen zwischen Ex-Bereich und nicht-explosionsgefährdeten Bereichen bekannt geworden. Die elektrische Sicherheitsbarriere ist wesentlich schlanker als herkömmliche Barrieren, aber erfüllt trotzdem alle notwendigen Zertifizierungsanforderungen der Zertifizierungsstellen. Die elektrische Sicherheitsbarriere weist elektrische Schaltkreiskomponenten auf, die durch ein aus einem keramischen Material gefertigte Substrat getragen sind.

Aus der DE 43 42 592 C1 ist eine Strombegrenzungsvorrichtung für elektrische Verbraucher bekannt, die von einer Spannungsquelle mit Energie versorgt wird. Die Strombegrenzungsvorrichtung weist einen Vorwiderstand auf, der zwischen dem elektrischen Verbraucher und der Spannungsquelle angeordnet ist. Der Vorwiderstand ist auf einer Folie aufgebracht, und die Folie selbst ist an der Gehäusewandung eines den elektrischen Verbraucher umschließenden Gehäuses angebracht. Dadurch wird erreicht, dass im Falle eines zu hohen Stromes die Wärme des Vorwiderstandes großflächig an die Umgebung abgegeben werden kann.

Aus der DE 38 34 514 A1 ist eine Überspannungsschutzanordnung bekannt, wobei ein Varistor mittels einem mit einem Kondensator in Reihe liegendem Widerstand einer eventuell auftretenden Schwingungsneigung entgegenwirkt. Varistoren, die aus Sinterkeramiken hergestellte Halbleiterbauelemente sind, weisen einen spannungsabhängigen nicht linearen Widerstand auf. Weiterhin sind sowohl der jeweilige Varistor als auch die jeweilige RC-Beschaltung an die in die Stromversorgungsleitungen eingeschleiften Temperatursicherungen thermisch angekoppelt. Hierbei wird durch geeignete Dimensionierung erreicht, dass die als Grobschutz dienende jeweilige Temperatursicherung schon vor dem Auftreten kritischer Temperaturauswirkungen (Kennlinienveränderung, Bauelement-Zerstörung, Bauelement-Auslötung) den Hauptstrompfad unterbricht.

Es ist eine Aufgabe der Erfindung ein Schutzelement und ein mit einem solchen Schutzelement ausgestattetes Gerät der eingangs genannten Art anzugeben, mit dem im Falle einer Fehlfunktion einer Baugruppe auf Platz sparende Weise eine sichere Umwandlung der über die übergeordnete Einheit bereit gestellten Leistung in Wärme sicher gestellt ist.

Die Aufgabe wird gelöst mit dem Schutzelement nach Anspruch 1.

Weiterhin betrifft die Erfindung ein mit einem Schutzelement gemäß Anspruch 1 ausgestattetes elektronisches Gerät nach Anspruch 2.

Gemäß einer bevorzugten Ausgestaltung besteht der Grundkörper aus Keramik, insb. aus Aluminiumnitrid (AIN).

Gemäß einer weiteren Ausgestaltung sind die Widerstände Dünnschichtwiderstände, insb. Dünnschichtwiderstände aus TaNi oder NiCr.

Gemäß einer ersten Weiterbildung ist auf einer den Widerständen gegenüberliegenden Seite des Grundkörpers eine Wärmeleitschicht, insb. eine metallische Beschichtung, aufgebracht.

Gemäß einer weiteren Weiterbildung der ersten Weiterbildung
- liegt das Schutzelement mit der die Wärmeleitschicht aufweisenden Seite des Grundkörpers auf einer Leiterplatte auf, und
- die Leiterplatte weist in einem von der Wärmeleitschicht überdeckten Bereich eine Ausnehmung auf.

Gemäß einer zweiten Weiterbildung
- ist das Schutzelement auf einer Leiterplatte angeordnet,
- ist die die Widerstände aufweisende Seite des Grundkörpers der Leiterplatte zugewandt, und
- sind die Leiterplatte und das Schutzelement durch Abstandshalter voneinander beabstandet.

Gemäß einer Weiterbildung der zweiten Weiterbildung ist zwischen der Leiterplatte und dem Schutzelement ein elektrisch isolierendes Wärmeleitelement angeordnet.

Gemäß einer Weiterbildung der zweiten Weiterbildung sind die Abstandshalter die Anschlüsse der Widerstände, die auf der die Widerstände aufweisenden Seite des Grundkörpers in vom Grundkörper abgewandter Richtung aus einer Ebene der Widerstände herausragen.

Gemäß einer dritten Weiterbildung ist eine die Widerstände aufweisende Seite des Schutzelements mit einer elektrisch isolierenden Wärmeleitschicht, insb. einem Lack oder einem Verguss, überzogen.

Darüber hinaus umfasst die Erfindung ein Schutzelement für den elektrischen Anschluss einer übergeordneten elektronischen Einheit an mehrere über die übergeordnete Einheit mit Energie zu versorgende elektronische Baugruppen, mit
- einem elektrisch isolierenden, wärmeleitfähigen Grundkörper,
- einer der Anzahl der Baugruppen entsprechenden Anzahl von parallel zueinander auf den Grundkörper aufgebrachten Widerständen, die jeweils eingangsseitig über einen Anschluss an die Einheit und ausgangseitig über einen Anschluss an eine der Baugruppen anschließbar sind.

Die Erfindung und weitere Vorteile werden nun anhand der Figuren der Zeichnung, in denen zwei Ausführungsbeispiele dargestellt sind, näher erläutert; gleiche Elemente sind in den Figuren mit denselben Bezugszeichen versehen.
- Fig. 1: zeigt: ein Blockschaltbild eines Geräts gemäß dem Stand der Technik;
- Fig. 2: zeigt: ein Blockschaltbild eines erfindungsgemäßen Geräts;
- Fig. 3: zeigt: eine Ansicht einer ersten Variante des erfindungsgemäßen Schutzelements;
- Fig. 4: zeigt: eine Unterseite des Schutzelements von Fig. 3;
- Fig. 5: zeigt: eine Schnittzeichnung des Schutzelements von Fig. 3 auf einer Leiterplatte;
- Fig. 6: zeigt: eine Teilansicht einer zweiten Variante des erfindungsgemäßen Schutzelements; und
- Fig. 7: zeigt: eine Schnittzeichnung des Schutzelements von Fig. 6 auf einer Leiterplatte.

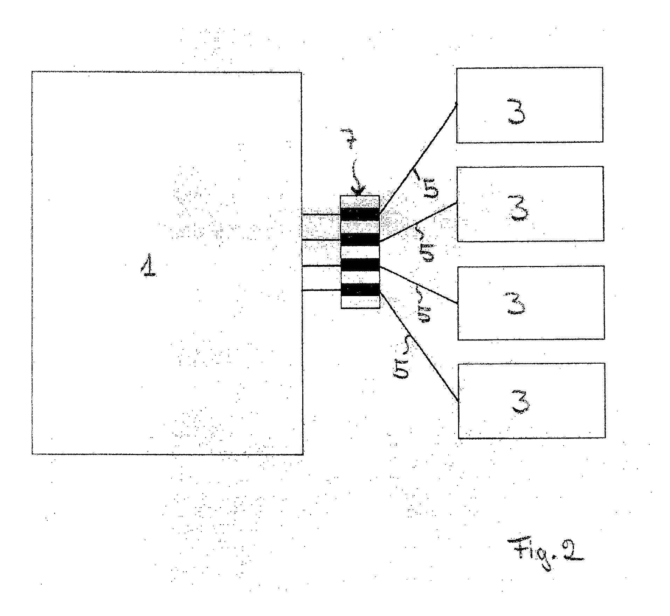

Fig. 2 zeigt ein Blockschaltbild eines erfindungsgemäßen elektronischen Geräts für den Einsatz in explosionsgefährdeten Bereichen. Es weist eine einzige übergeordnete elektronische Einheit 1 auf, an die mehrere untergeordnete elektronische Baugruppen 3 angeschlossen sind. Die Baugruppen 3 sind jeweils über eine Anschlussleitung 5 an die übergeordnete Einheit 1 angeschlossen, und werden von der übergeordneten Einheit 1 mit Energie versorgt.

Erfindungsgemäß ist ein in mehrere jeweils eine der Baugruppen 3 mit der übergeordneten Einheit 1 verbindende Anschlussleitungen 5 eingesetztes Schutzelement 7 vorgesehen. In dem dargestellten Ausführungsbeispiel sind alle Baugruppen 3 über das dargestellte Schutzelement 7 mit der übergeordneten Einheit 1 verbunden. Alternativ können aber auch mehrere Gruppen von Baugruppen jeweils über ein einzelnes in die Anschlussleitungen aller Baugruppen der jeweiligen Gruppe eingesetztes Schutzelement an die übergeordnete Einheit 1 angeschlossen werden.

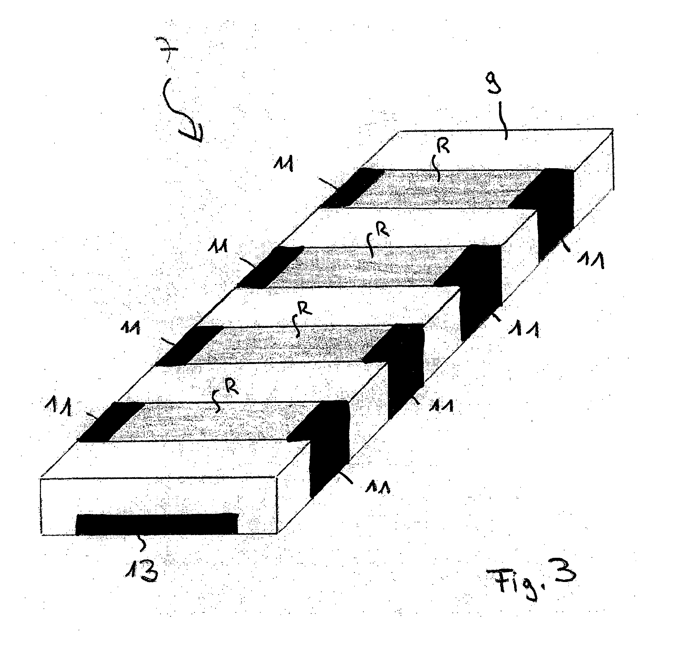

Fig. 3 zeigt eine erste Variante eines erfindungsgemäßen Schutzelements 7.
Es umfasst einen Grundkörper 9 aus einem elektrisch isolierenden, wärmeleitfähigen Material, wie z.B. Keramik. Ein aufgrund seiner hohen Wärmeleitfähigkeit in der Größenordung von 200 W/mK besonders geeigneter keramischer Werkstoff ist z.B. Aluminiumnitrid (AIN).

Auf dem Grundkörper 9 ist eine der Anzahl der über das Schutzelement 7 führenden Anschlussleitungen 5 entsprechende Anzahl von Widerstanden R aufgebracht. Die Widerstände R sind vorzugsweise Dünnschichtwiderstände, insb. Dünnschichtwiderstände aus TaNi oder NiCr.

Jeder Widerstand R ist jeweils eingangs- und ausgangsseitig mit einem Anschluss 11 für eine der Anschlussleitungen 5 versehen. In der in Fig. 3 dargestellten Variante sind die Widerstände R hierzu als streifenförmige Flächenwiderstände ausgebildet, die parallel zueinander quer über eine Oberseite des Grundkörpers 9 verlaufen. Die eingangs- und ausgangsseitig vorgesehenen Anschlüsse 11 sind beispielsweise auf gegenüberliegenden Seitenflächen des Grundkörpers 9 angeordnete jeweils mit den Enden der Widerstände R auf der Oberseite des Grundkörpers 9 verbundene SMD-Lötanschlüsse.

Im Falle einer Fehlfunktion einer oder mehrerer über das Schutzelement 7 an die übergeordnete Einheit 1 angeschlossenen Baugruppen 3 ist die über die übergeordnete Einheit 1 zur Verfügung stehende Energie sicher in Wärme umzusetzen. Da nur eine übergeordnete Einheit 1 vorhanden ist, ist diese Energie auch nur einmal vorhanden, unabhängig davon, wie viele Baugruppen 3 über das Schutzelement 7 an die übergeordnete Einheit 1 angeschlossen sind. Anders als beim eingangs beschriebenen Stand der Technik, bei dem jeder einzelne Schutzwiderstand R_{Ex} in der Lage sein muss, die von der übergeordneten Einheit 1 zur Verfügung gestellte Energie im Fehlerfall sicher in Wärme umzusetzen, genügt hier die einmalige Umsetzung durch das Schutzelement 7, unabhängig von der Anzahl der darüber angeschlossenen Baugruppen 3.

Eine Fehlfunktion einer der Baugruppen 3 führt zu einem erhöhten Strom über den in dessen Anschlussleitung 5 befindlichen Widerstand R des Schutzelements 7. Die dabei frei werdende Wärme wird vom Grundkörper 9 aufgenommen und über den Grundkörper 9 abgeführt. Dabei bewirkt die vorzugsweise hohe Wärmeleitfähigkeit des Grundkörpers 9 eine näherungsweise gleichförmige Erwärmung des Grundkörpers 9 und damit einen effektiven großflächigen Wärmeabtransport. Eine gleichzeitig auftretende Fehlfunktion von zwei oder mehr Baugruppen 3 führt aufgrund der nur einmal vorhandenen in Wärme umzusetzenden Energie nicht zu einer höheren Wärmeentwicklung am Schutzelement 7. Auch bei gleichzeitiger Fehlfunktion mehrer Baugruppen 3 genügt damit ein einziger Grundkörper 9 zur sicheren Wärmeumsetzung. Erfindungsgemäß wird daher für den Anschluss mehrerer Baugruppen 3 an eine übergeordnete Einheit 1 nur ein einziger zentral angeordneter Grundkörper 9 benötigt. Damit wird sehr viel Platz eingespart, der nun für Miniaturisierung des Geräts, für weitere Baugruppen oder für andere Nutzungen zur Verfügung steht.

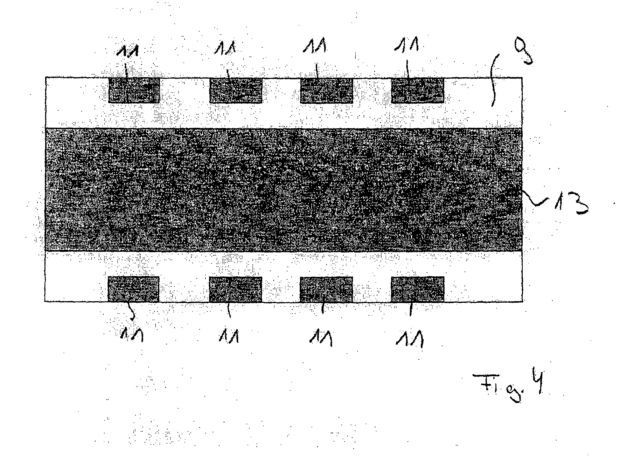

Zur Verbesserung des Wärmeabtransports kann auf einer den Widerständen R gegenüberliegenden Seite des Grundkörpers 9 eine in Fig. 4 dargestellte Wärmeleitschicht 13, insb. eine metallische Beschichtung, aufgebracht bzw. - wie hier dargestellt - in eine entsprechende Ausnehmung in den Grundkörper 9 eingebracht sein. Hierdurch ist es möglich entweder die vom Schutzelement 7 umsetzbare Wärmemenge, und damit die über die übergeordnete Einheit 1 zur Verfügung stellbare Energie zu erhöhen, oder bei gleicher über die übergeordnete Einheit 1 zur Verfügung stehender Energie die Abmessungen des Grundkörpers 9 zu reduzieren.

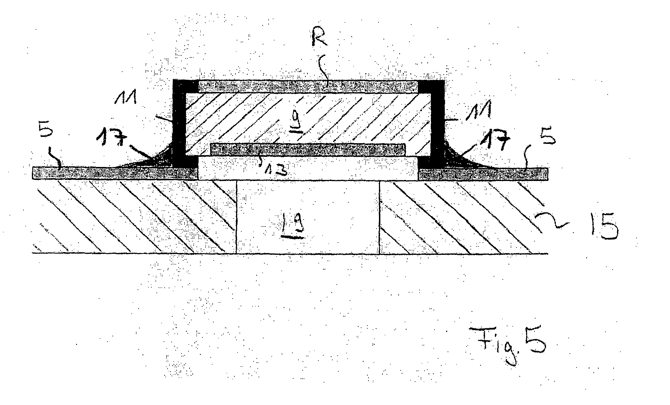

Das Schutzelement 7 ist beispielsweise - wie in Fig. 5 dargestellt- auf einer Leiterplatte 15 angeordnet, auf deren Oberseite die Anschlussleitungen 5 zur übergeordneten Einheit 1 und zu den Baugruppen 3 aufgebracht sind, in die das Schutzelement 7 eingesetzt ist. Die Anschlussleitungen 5 führen jeweils zu den auf den gegenüberliegenden Seiten des Grundkörpers 9 angeordneten Anschlüssen 11 der Widerstände R, an die sie jeweils beispielsweise über eine Lötverbindung 17 angeschlossen sind. Vorzugsweise dienen diese Lötverbindungen 17 zugleich auch zur mechanischen Befestigung des Schutzelements 7 auf der Leiterplatte 15.

Zur weiteren Verbesserung des Wärmeabtransports im Falle einer Fehlfunktion, weist die Leiterplatte 15 in deren vom Schutzelement 7 überdeckten Bereich eine Ausnehmung 19 auf, über die Wärme durch die Leiterplatte 15 hindurch abgeführt wird. Diese Maßnahme führt insb. in Kombination mit einer auf der der Leiterplatte 15 zugewandten Seite des Grundkörpers 9 vorgesehenen Wärmeleitschicht 13 zu einem sehr effektiven Wärmeabtransport. Alternativ kann die Wärmeleitschicht 13 aber auch auf einer auf der Leiterplatte 15 vorgesehenen hier nicht dargestellten Kühlfläche aufgebracht bzw. aufgelötet werden.

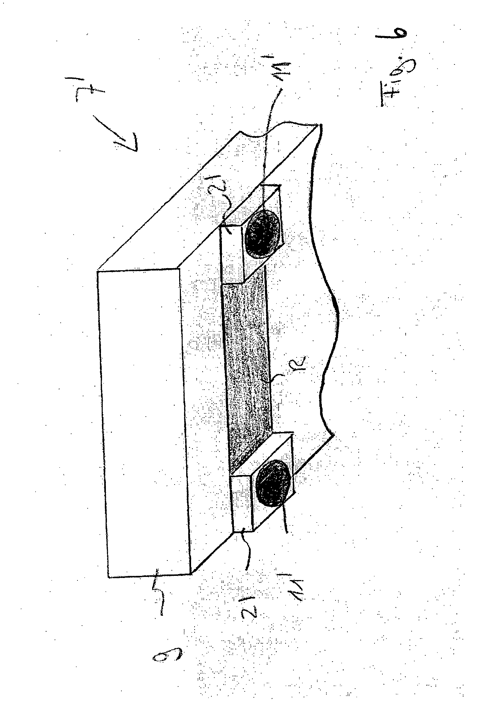

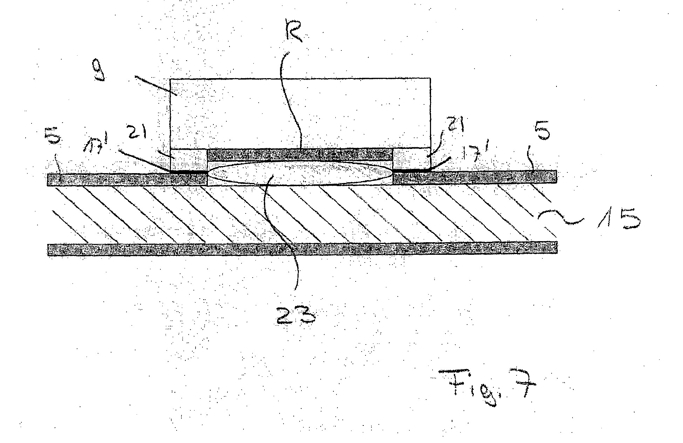

Fig. 6 zeigt einen Ausschnitt einer weiteren Variante des erfindungsgemäßen Schutzelement 7'. Aufgrund der großen Übereinstimmung zu der zuvor beschriebenen Variante sind hier lediglich die bestehenden Unterschiede näher erläutert. Im Unterschied zu der bisher beschriebenen Variante sind die Widerstände R und deren Anschlüsse 11' hier auf ein und derselben Seite des Grundkörpers 9 angeordnet. Hierdurch ist es unter Einsatz von Abstandshaltern 21 zwischen Leiterplatte 15 und Grundkörper 9 möglich, das Schutzelement 7' -wie in Fig. 7 dargestellt- derart auf der Leiterplatte 15 zu montieren, dass die Widerstände R sich auf der der Leiterplatte 15 zugewandten Seite des Grundkörpers 9 befinden.

Die Abstandshalter 21 werden vorzugsweise durch die Anschlüsse 11' der Widerstände R gebildet, die hierzu auf der die Widerstände R aufweisenden Seite des Grundkörpers 9 in vom Grundkörper 9 abgewandter Richtung aus einer Ebene der Widerstände R herausragen. Die Anschlüsse 11' sind auch hier vorzugsweise über Lötverbindungen 17' an die auf der Leiterplatte 15 zum Schutzelement 7' verlaufenden Anschlussleitungen 5 angeschlossen.

Genau wie bei dem in Fig. 5 dargestellten Ausführungsbeispiel kann auch hier in dem vom Schutzelement 7 überdeckten Bereich der Leiterplatte 15 eine -hier nicht dargestellte-Ausnehmung zur Verbesserung des Wärmeabtransports durch die Leiterplatte 15 hindurch vorgesehen werden.

Alternativ kann zwischen der Leiterplatte 15 und Schutzelement 7 zur Verbesserung des Wärmeabtransports ein elektrisch isolierendes Wärmeleitelement 23 angeordnet werden.

Darüber hinaus ist vorzugsweise zumindest die die Widerstände R aufweisende Seite des Schutzelements 7 bzw. 7' mit einer elektrisch isolierenden Wärmeleitschicht, insb. einem Lack oder einem Verguss, überzogen. Diese Wärmeleitschicht bietet zum einen den Vorteil, dass sie die gleichmäßige Verteilung der lokalen Wärmeentwicklung im Bereich einzelner Widerstände R über den Grundkörper 9 fördert und beschleunigt. Zum anderen bewirkt sie eine Verstärkung der durch den Abstand zwischen den einzelnen Widerständen R gegebenen Isolierung der einzelnen Widerstände R gegeneinander, und trägt damit zur Erhöhung der Spannungsfestigkeit bei.
- 1: übergeordnete Einheit
- 3: Baugruppe
- 5: Anschlussleitung
- 7: Schutzelement
- 7': Schutzelement
- 9: Grundkörper
- 11: Anschluss
- 11': Anschluss
- 13: Wärmeleitschicht
- 15: Leiterplatte
- 17: Lötverbindung
- 19: Ausnehmung in der Leiterplatte
- 21: Abstandshalter
- 23: Wärmeleitelement

## Patentansprüche

1. Schutzelement (7, 7') für den elektrischen Anschluss einer übergeordneten elektronischen Einheit (1) an mehrere über die übergeordnete Einheit (1) mit Energie zu versorgende elektronische Baugruppen (3), mit
- einem elektrisch isolierenden, wärmeleitfähigen Grundkörper (9),
- einer der Anzahl der Baugruppen (3) entsprechenden Anzahl von auf den Grundkörper (9) aufgebrachten Widerständen (R),
die jeweils eingangsseitig über einen Anschluss (11, 11') an die Einheit (1) und ausgangseitig über einen Anschluss (11, 11') an eine der Baugruppen (3) anschließbar sind.

2. Elektronisches Gerät für den Einsatz in explosionsgefährdeten Bereichen, mit
- der übergeordneten elektronischen Einheit (1),
- den mehreren an die übergeordnete Einheit (1) angeschlossenen von der übergeordneten Einheit (1) mit Energie versorgten elektronischen Baugruppen (3), und
- dem in die mehreren Anschlussleitungen (5) für den Anschluss jeweils einer der Baugruppen (3) an die übergeordnete Einheit (1) eingesetzten Schutzelement (7, 7') nach Anspruch 1, wobei die Widerständen (R) jeweils in eine der Anschlussleitungen (5) eingesetzt sind.

3. Elektronisches Gerät nach Anspruch 2, bei dem
der Grundkörper (9) aus Keramik, insb. aus Aluminiumnitrid (AIN), besteht.

4. Elektronisches Gerät nach Anspruch 2, bei dem
die Widerstände (R) Dünnschichtwiderstände, insb. Dünnschichtwiderstände aus TaNi oder NiCr, sind.

5. Elektronisches Gerät nach Anspruch 2, bei dem
auf einer den Widerständen (R) gegenüberliegenden Seite des Grundkörpers (9) eine Wärmeleitschicht (13), insb. eine metallische Beschichtung, aufgebracht ist.

6. Elektronisches Gerät nach Anspruch 5, bei dem
- das Schutzelement (7) mit der die Wärmeleitschicht (13) aufweisenden Seite des Grundkörpers (9) auf einer Leiterplatte (15) aufliegt, und
- die Leiterplatte (15) in einem von der Wärmeleitschicht (13) überdeckten Bereich eine Ausnehmung (19) aufweist.

7. Elektronisches Gerät nach Anspruch 2, bei dem
- das Schutzelement (7') auf einer Leiterplatte (15) angeordnet ist,
- die die Widerstände (R) aufweisende Seite des Grundkörpers (9) der Leiterplatte (15) zugewandt ist, und
- die Leiterplatte (15) und das Schutzelement (7') durch Abstandshalter (21) voneinander beabstandet sind.

8. Elektronisches Gerät nach Anspruch 7, bei dem
zwischen der Leiterplatte (15) und dem Schutzelement (7') mindestens ein elektrisch isolierendes Wärmeleitelement (23) angeordnet ist.

9. Elektronisches Gerät nach Anspruch 7, bei dem
die Abstandshalter (21) die Anschlüsse (11') der Widerstände (R) sind, die auf der die Widerstände (R) aufweisenden Seite des Grundkörpers (9) in vom Grundkörper (9) abgewandter Richtung aus einer Ebene der Widerstände (R) herausragen.

10. Elektronisches Gerät nach Anspruch 2, bei dem
eine die Widerstände (R) aufweisende Seite des Schutzelements (7, 7') mit einer elektrisch isolierenden Wärmeleitschicht, insb. einem Lack oder einem Verguss, überzogen ist.

## Claims

1. Protective element (7, 7') for the electrical connection of a higher-level electronic unit (1) to several assemblies (3) that are to be supplied with energy via the higher- level unit (1), with
- an electrically insulating meter body (9) that conducts heat
- a number of resistors (R) fitted on the meter body (9) that corresponds to the number of assemblies (3),
wherein said resistors can be connected in each case on the input side to the unit (1) via a connection (11, 11'), and can be connected on the output side to one of the assemblies (3) via a connection (11, 11').

2. Electronic device for use in hazardous areas,
with
- the higher-level electronic unit (1),
- the multiple electronic assemblies (3) that are connected to the higher-level unit (1) and supplied with energy by the higher-order unit (1), and
- the protective element (7, 7') as per Claim 1, which is inserted into the multiple connecting cables (5) for the connection in each case of one of the assemblies (3) to the higher-level unit (1), wherein the resistors (R) are inserted into one of the connecting cables (5) in each case.

3. Electronic device as claimed in Claim 2, wherein
the meter body (9) is made from ceramic, especially aluminum nitride (AIN).

4. Electronic device as claimed in Claim 2, wherein the resistors (R) are thin-film resistors, particularly thin-film resistors made from TaNi or NiCr.

5. Electronic device as claimed in Claim 2, wherein a heat conduction layer (13), particularly a metal coating, is applied to a side of the meter body (9) that is opposite the resistors (R).

6. Electronic device as claimed in Claim 5, wherein
- the protective element (7) with the side of the meter body (9) that bears the heat conduction layer (13) rests on a printed circuit board (15), and
- the printed circuit board (15) has a cavity (19) in an area covered by the heat conduction layer (13).

7. Electronic device as claimed in Claim 2, wherein
- the protective element (7') is arranged on a printed circuit board (15)
- the side of the meter body (9) that bears the resistors (R) faces towards the printed circuit board (15)
- the printed circuit board (15) and the protective element (7') are spaced at a distance from one another by spacers (21).

8. Electronic device as claimed in Claim 7, wherein
at least one electrically insulating heat conduction element (23) is arranged between the printed circuit board (15) and the protective element (7').

9. Electronic device as claimed in Claim 7, wherein
the spacers (21) are the connections (11') of the resistors (R) that project out of a plane of the resistors (R) on the side of the meter body (9) that bears the resistors in the direction facing away from the meter body (9).

10. Electronic device as claimed in Claim 2, wherein
one side of the protective element (7, 7') bearing the resistors (R) is covered with an electrically insulating heat conduction layer, particularly a varnish or a potting compound.

## Revendications

1. Elément de protection (7, 7') pour le raccordement électrique d'une unité électronique maître (1) à plusieurs modules électroniques (3) devant être alimentés en énergie par l'intermédiaire de l'unité maître (1), avec
- un corps de base (9) thermoconducteur, électriquement isolant,
- un nombre de résistances (R) disposées sur le corps de base (9) correspondant au nombre de modules (3), lesquelles résistances peuvent être raccordées, côté entrée, via une connexion (11, 11') à l'unité (1) et, côté sortie, via une connexion (11, 11') à l'un des modules (3).

2. Appareil électronique destiné à une utilisation dans des zones à atmosphère explosible, avec
- l'unité électronique maître (1),
- les plusieurs modules électroniques (3) alimentés en énergie par l'unité maître (1) et raccordés à l'unité maître (1), et
- l'élément de protection (7, 7') selon la revendication 1, inséré dans les plusieurs câbles de liaison (5) pour le raccordement respectif de l'un des modules (3) à l'unité maître (1), les résistances (R) étant chacune insérées dans l'un des câbles de liaison (5).

3. Appareil électronique selon la revendication 2, pour lequel
le corps de base (9) est en céramique, notamment en nitrure d'aluminium (AlN).

4. Appareil électronique selon la revendication 2, pour lequel
les résistances (R) sont des résistances à couche mince, notamment des résistances à couche mince en TaNi ou en NiCr.

5. Appareil électronique selon la revendication 2, pour lequel
est appliquée une couche thermoconductrice (13), notamment un revêtement métallique, sur le côté du corps de base (9) situé à l'opposé des résistances (R).

6. Appareil électronique selon la revendication 5, pour lequel
- l'élément de protection (7) repose sur un circuit imprimé (15) avec le côté du corps de base (9) présentant la couche thermoconductrice (13), et
- le circuit imprimé (15) présente une cavité (19) dans une zone couverte par la couche thermoconductrice (13).

7. Appareil électronique selon la revendication 2, pour lequel
- l'élément de protection (7') est disposé sur un circuit imprimé (15),
- le côté du corps de base (9) comportant les résistances (R) fait face au circuit imprimé (15), et
- le circuit imprimé (15) et l'élément de protection (7') sont espacés l'un par rapport l'autre au moyen d'entretoises (21).

8. Appareil électronique selon la revendication 7, pour lequel
est disposé au moins un élément thermoconducteur (23) électriquement isolant entre le circuit imprimé (15) et l'élément de protection (7').

9. Appareil électronique selon la revendication 7, pour lequel
les entretoises (21) sont les connexions (11') des résistances (R), qui s'étendent hors d'un plan des résistances (R) sur le côté du corps de base (9) comportant les résistances (R), dans la direction opposée au corps de base (9).

10. Appareil électronique selon la revendication 2, pour lequel
un côté de l'élément de protection (7, 7') comportant les résistances (R) est couvert d'une couche thermoconductrice électriquement isolante, notamment un vernis ou un engobage
